(19) Europäisches Patentamt
European Patent Office
Office européen des brevets

(11) Veröffentlichungsnummer : **0 042 105**
**B1**

# (12) EUROPÄISCHE PATENTSCHRIFT

(45) Veröffentlichungstag der Patentschrift : **30.07.86**

(51) Int. Cl.⁴ : **G 03 F 7/02**, G 03 C 1/495, G 03 C 1/52, G 03 C 1/68, G 03 C 1/74

(21) Anmeldenummer : **81104260.5**

(22) Anmeldetag : **03.06.81**

## (54) Lichtempfindliches Kopiermaterial und Verfahren zu seiner Herstellung.

(30) Priorität : **14.06.80 DE 3022362**

(43) Veröffentlichungstag der Anmeldung : **23.12.81 Patentblatt 81/51**

(45) Bekanntmachung des Hinweises auf die Patenterteilung : **30.07.86 Patentblatt 86/31**

(84) Benannte Vertragsstaaten : **AT BE CH DE FR GB IT LI NL SE**

(56) Entgegenhaltungen : **DE-A- 2 914 558**

(73) Patentinhaber : **HOECHST AKTIENGESELLSCHAFT**
**Postfach 80 03 20**
**D-6230 Frankfurt am Main 80 (DE)**

(72) Erfinder : **Lehmann, Peter, Dr.**
**An der Ziegelei 12**
**D-6233 Kelkheim (DE)**
Erfinder : **Mohr, Dieter, Dr.**
**Prinz-Ratibor-Strasse 2**
**D-6200 Wiesbaden (DE)**
Erfinder : **Reiss, Kurt, Dr.**
**Lohmühlweg 7**
**D-6200 Wiesbaden (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

EP 0 042 105 B1

**Beschreibung**

Die Erfindung betrifft ein lichtempfindliches Kopiermaterial sowie ein Verfahren zu seiner Herstellung durch Beschichten eines Schichtträgers mit einer Lösung der Bestandteile der lichtempfindlichen Schicht in einem Lösungsmittel, vorzugsweise einem organischen Lösungsmittel, und Trocknen.

Es ist üblich, lichtempfindliche Kopiermaterialien der verschiedensten Arten durch möglichst gleichmäßiges Beschichten von Schichtträgern aus Metallen, Kunststoffolien, Papier, Geweben und dgl. mit einer Lösung der Schichtbestandteile und Trocknen der Lösung unter solchen Bedingungen, daß eine möglichst gleichmäßige Schicht entsteht, herzustellen.

Als Schichtbestandteile kommen im allgemeinen lichtempfindliche bzw. photoleitfähige Verbindungen oder Kombinationen von Verbindungen, Bindemittel, Farbstoffe, Pigmente, Weichmacher, Füllstoffe, polymerisierbare Verbindungen, Stabilisatoren und dgl. in Betracht. Die Bestandteile werden vorzugsweise in organischen Lösungsmitteln, seltener in Wasser oder Gemischen von Wasser und organischen Lösungsmitteln gelöst.

Bei der Beschichtung im großtechnischen Maßstab und bei kontinuierlicher Arbeitsweise verwendet man praktisch immer Gemische von mehreren Lösungsmitteln mit unterschiedlichen Verdunstungszahlen, um einen möglichst kontinuierlichen Übergang von der flüssigen Filmphase zu der trockenen Schicht zu erreichen und eine Entmischung während des Trocknens nach Möglichkeit zu verhindern. Man erreicht das zumeist durch Kombination von guten Lösern mit Nichtlösern, wobei Dampfdruck und Verdunstungszahlen der Bestandteile so gewählt werden, daß die Nichtlöser beim Trocknen bevorzugt verdunsten. Man erhält auf diese Weise Schichten, die eine ausreichende Beschichtungsqualität aufweisen, jedoch, sofern sie nicht farblos sind, immer noch eine gewisse Ungleichmäßigkeit, die als Wolkigkeit bezeichnet wird, erkennen lassen.

Mit Wolkigkeit wird das Vorliegen von helleren und dunkleren Schichtbereichen mit Durchmessern von etwa 1 bis 10 mm nebeneinander bezeichnet. Durch rasterelektronenmikroskopische (REM) Aufnahmen von Schnitten durch Kopierschichten wurde gefunden, daß das Auftreten von Farbdichteschwankungen auf Unterschiede in der Schichtdicke zurückzuführen ist.

Es wird angenommen, daß es während des Trocknungsvorgangs bis zum Eintreten der Gelphase zu Wirbeln oder Substanzbewegungen in der noch flüssigen Schicht kommt, die durch Veränderungen der Oberflächenspannung der trocknenden Schicht verursacht werden. Durch Verdunstung des Lösungsmittels ergeben sich zwei sich gegenseitig verstärkende Faktoren, die die Oberflächenspannung der trocknenden Schicht an der Grenzfläche zur Luft erhöhen. Zum einen führt die Temperaturabnahme zu einem Ansteigen der Oberflächenspannung in einer Größenordnung von 0,1 mN/m/°C, zum anderen tritt durch die Konzentrationserhöhung der filmbildenden Substanzen in der Lösung auch eine Erhöhung der Oberflächenspannung ein.

Ausgehend von zahlreichen kleinen Quellpunkten in der darunterliegenden Schicht weniger konzentrierter Lösung, kommt es zum Durchbruch von wärmerem Material mit geringerer Oberflächenspannung an die Oberfläche. Als Folge davon bilden sich an der Oberfläche entsprechende Zentren, von denen aus sich die von unten kommende Flüssigkeit ausbreitet, bis sich die Fronten der Spreitwellen benachbarter Zentren treffen. Durch Ablenkung der Flüssigkeitsbewegung in das Schichtinnere kommt es dann zur Wirbelbildung.

Bei der Herstellung lichtempfindlicher Druckplatten, insbesondere Flachdruckplatten, bei der oft mit relativ verdünnten Lösungen niedriger Viskosität gearbeitet wird, tritt dieses Phänomen besonders stark auf. Hier werden häufig wolkige, in der Schichtdicke und Färbung uneinheitliche Schichten erhalten. Solche Unregelmäßigkeiten der Schichtdicke wirken sich auf das Druckergebnis negativ aus, insbesondere bei Platten für den rasterlosen Offsetdruck. Die Oberflächenstruktur der Platte wird dabei in Grautonstufen mit abgebildet, so daß keine einheitlichen Grauflächen gedruckt werden.

Aus Research Disclosure (1976) 145, S. 15, Nr. 14522, ist es bekannt, lithographischen Schichten eine Kombination eines nichtionischen Netzmittels, Isononylphenoxydecaglycid, und eines anionischen Netzmittels, des Ammoniumsalzes von Nonylphenoxy-polyoxyäthylen-äthylsulfat, zur Verbesserung der Vergießbarkeit der Beschichtungslösung bei guter Farbannahme zuzusetzen. Ein Netzmittel allein reicht hiernach nicht aus, um die gewünschten Eigenschaften zu erzielen ; das nichtionische Netzmittel allein bewirkt eine Verschlechterung der Farbannahme und ein Tonen des Hintergrunds.

Aus der DE-OS 29 14 558 ist ein Beschichtungsverfahren bekannt geworden, bei dem die Gleichmäßigkeit der lichtempfindlichen Schichten von Flachdruckplatten dadurch verbessert wird, daß man der Beschichtungslösung ein Polymeres zusetzt, das ein Molekulargewicht von mindestens 10 000 hat und mindestens eine Fluoralkylgruppe enthält. Durch Zusatz dieser polymeren Verbindungen wird, wie in der Beschreibung angegeben ist, eine gleichmäßigere Schichtdicke erzielt. Zwar wird in der Beschreibung angegeben, daß eine Reihe von Lösungsmitteln sowohl allein als auch im Gemisch zur Herstellung der Beschichtungslösung verwendet werden können, doch werden in den Beispielen ausschließlich Gemische von Lösungsmitteln verwendet, von denen jeweils eines niedrig und eines hoch siedet.

Auch hat die Verwendung von hochmolekularen Verbindungen mit fluorierten Seitenketten den Nachteil, daß diese Polymeren nicht mehr in allen gebräuchlichen Lösungsmitteln löslich sind, so daß die Wahl des Lösungsmittels eingeschränkt wird.

Aufgabe der Erfindung was es, ein lichtempfindliches Kopiermaterial vorzuschlagen, das sich mit einfachen Mitteln mit lichtempfindlichen Schichten hoher Qualität und Gleichmäßigkeit beschichten läßt, zu dessen Herstellung eine Vielzahl von Lösungsmitteln verwendet werden können und das gewünschtenfalls aus einer Lösung in einem einzigen Lösungsmittel hergestellt werden kann.

Die Erfindung geht aus von einem lichtempfindlichen Kopiermaterial aus einem Schichtträger und einer lichtempfindlichen Schicht, die ihre Löslichkeit in einem Entwickler bei Belichtung mit aktinischem Licht ändert und die 0,01-10, bevorzugt 0,05-5, Gew.-% einer fluorierten organischen Verbindung enthält, dadurch gekennzeichnet, daß die fluorierte organische Verbindung ein fluoriertes nichtionogenes Netzmittel ist, das der Ester einer Perfluoralkansäure mit einem Polyalkylenglykol oder der Äther eines hoch- oder perfluorierten Alkanols mit einem Polyalkylenglykol ist und das die Formel

$R_f(CO)_r(OC_mH_{2m})_nOR$ aufweist,

worin

$R_f$ ein fluorierter Alkylrest mit 2 bis 12, vorzugsweise 5 bis 8 Kohlenstoffatomen,
R ein Wasserstoffatom oder ein Rest $R_f(CO)_r$,
m eine Zahl von 2 bis 5, vorzugsweise 2 oder 3,
n eine Zahl von 4 bis 40, und
r Null oder 1

ist.

Erfindungsgemäß wird ferner ein Verfahren zum Beschichten eines Schichtträgers mit einer lichtempfindlichen Kopierschicht vorgeschlagen, bei dem die Schichtbestandteile zusammen mit einer fluorierten organischen Verbindung in einem Lösungsmittel gelöst werden, die Lösung zu einer dünnen, gleichmäßigen Schicht auf den Träger aufgebracht und durch Verdunsten des Lösungsmittels, vorzugsweise bei erhöhter Temperatur, getrocknet wird. Das Verfahren ist dadurch gekennzeichnet, daß man der Beschichtungslösung 0,005 bis 1, vorzugsweise 0,01 bis 0,05 Gew.-% eines nichtionogenen fluorierten Netzmittels zusetzt, das der Ester einer Perfluoralkansäure mit einem Polyalkylenglykol oder der Äther eines hoch- oder perfluorierten Alkohols mit einem Polyalkylenglykol ist und das die Formel

$R_f(CO)_r(OC_mH_2m)_nOR$ aufweist,

worin

$R_f$ ein fluorierter Alkylrest mit 2 bis 12, vorzugsweise 5 bis 8 Kohlenstoffatomen,
R ein Wasserstoffatom oder ein Rest $R_f(CO)_r$,
m eine Zahl von 2 bis 5,. vorzugsweise 2 oder 3,
n eine Zahl von 4 bis 40, und
r Null oder 1

ist.

Wenn r = 0 ist, hat n bevorzugt einen Wert von 4 bis 15, insbesondere 5 bis 10. Wenn r = 1 ist, ist n bevorzugt eine Zahl von 8 bis 35.

Der fluorierte Alkylrest $R_f$ hat bevorzugt die folgende Zusammensetzung :

$$C_kF_{2k+1}C_qH_{2q},$$

worin k eine Zahl von 2 bis 12 und q Null oder eine Zahl von 1 bis 5 bedeutet, wobei q = 0 ist, wenn r = 1 ist, und die Summe k + q nicht größer als 12 ist.

Die fluorierten Netzmittel haben Molekulargewichte im Bereich von 300 bis 3 500, vorzugsweise von 450 bis 2 600.

Die Wirkung der fluorierten Netzmittel hängt wesentlich von dem verwendeten Lösungsmittel ab. Dagegen spielt die chemische Natur und die Zusammensetzung der gelösten bzw. dispergierten Schichtbestandteile, insbesondere der lichtempfindlichen Substanzen, eine untergeordnete Rolle.

Für jede Schichtzusammensetzung läßt sich ein geeignetes Lösungsmittel leicht durch Vorversuche ermitteln. Dabei soll das zugesetzte Netzmittel bei Anwendung in Konzentrationen innerhalb der oben angegebenen Bereiche die Oberflächenspannung der jeweiligen Beschichtungslösung gegenüber Luft um 1 bis 6 mN/m herabsetzen. Die Oberflächenspannung der trockenen Schicht gegenüber Wasser soll durch den Netzmittelzusatz um 2 bis 10, vorzugsweise 5 bis 8 mN/m herabgesetzt werden.

Die fluorierten Netzmittel reichern sich aufgrund ihrer starken oberflächenaktiven Wirkung an der Grenzfläche der Beschichtungslösung an. Dies führt besonders bei rauhen Trägeroberflächen mit sehr hoher Oberflächenspannung zu einer Verminderung der Spreittendenz der Lösung. Vermutlich wird auch das Spreiten von Flüssigkeitsphasen niedriger Trocknungsgrade und Konzentrationen auf Filmphasen höherer Trocknungsgrade durch Anreicherung der Netzmittel an den Grenzflächen weitgehend unterdrückt. Dadurch werden wahrscheinlich Bewegungen des Flüssigkeitsfilms während der Trocknung stark gehemmt, und es entstehen gleichmäßigere Schichten nach der Trocknung.

Diese positive Wirkung zeigen jedoch nur wenige der zahlreichen bekannten Netzmittel. Als entscheidend für die Wirkung der in der vorliegenden Anmeldung beschriebenen Netzmittel wird die Kombination eines hochfluorierten Restes mit einer Polyätherkette in einem Molekül angesehen. Obwohl diese Netzmittel wegen ihrer stark oberflächenaktiven Eigenschaften und ihres relativ niedrigen Molekulargewichts in erheblichem Maße an der Oberfläche der sich ausbildenden Schicht angereichert werden, beeinträchtigen sie weder die Bilddifferenzierung bei der Entwicklung noch die Oleophilie der im Entwickler unlöslichen Bildbereiche oder die Druckauflage der erhaltenen Druckform.

Als weiteres Maß für die Brauchbarkeit eines Netzmittels und für die Bestimmung seines geeigneten Konzentrationsbereichs in der Beschichtungslösung hat sich das Spreitvermögen der Lösung erwiesen. Dieses läßt sich leicht dadurch ermitteln, daß man eine definierte Menge der Lösung auf einen bestimmten Träger aufgibt und nach dem Trocknen bei Raumtemperatur den Durchmesser der Benetzungszone ausmißt. Als Träger verwendet man dabei zweckmäßig ein Material von sehr gleichmäßiger Rauhigkeit der Oberfläche, z. B. elektrolytisch aufgerauhtes Aluminium, da auf diesem Material die zu beobachtenden Effekte am deutlichsten hervortreten und am sichersten reproduzierbar sind.

Die auf solchem Trägermaterial ermittelten Werte für die spreitungshemmende Wirkung eines Netzmittels können mit guter Näherung auch auf das Verhalten auf einem völlig andersgearteten Trägermaterial (z. B. Polyesterfolie) übertragen werden.

Bei Zusatz der oben definierten fluorierten Netzmittel zur Beschichtungslösung soll das Spreitvermögen der Lösung um 40 bis 75, vorzugsweise um 50 bis 70 %, bezogen auf den Durchmesser der Benetzungszone, reduziert werden.

Bereits bei Zusatz sehr kleiner Mengen der fluorierten Netzmittel (weniger als 0,1 %) zu der Beschichtungslösung, die im übrigen lichtempfindliche bzw. photoleitfähige Substanzen, ggf. Bindemittel, Farbstoffe und andere übliche Bestandteile, gelöst in einem üblichen Lösungsmittelgemisch eines hoch- und niedrigsiedenden Lösungsmittel, z. B. Äthylenglykolmonomethyläther/Tetrahydrofuran oder Äthylenglykolmonomethyläther/Butylacetat/Tetrahydrofuran enthält, wird bei der Beschichtung üblicher Trägermaterialien, z. B. von Aluminium, eine wolkenfreie, optisch gleichmäßige, in Färbung und Schichtdicke einheitliche Kopierschicht erhalten. Die so hergestellten Kopierschichten übertreffen im Hinblick auf ihre Beschichtungsqualität den Standard, wie er gegenwärtig insbesondere bei vorsensibilisierten Flachdruckplatten üblich und erreichbar ist.

Als Lösungsmittel für die Beschichtungslösungen kommen in bekannter Weise u. a. Alkohole, Ätheralkohole, Amide, chlorierte Kohlenwasserstoffe und Ketone in Betracht, z. B. Äthylenglykolmonomethyläther, Äthylenglykolmonoäthyläther, Äthylenglykolmonoisopropyläther, Dimethylformamid, Diacetonalkohol, Butyrolacton, Methylendichlorid, Dichloräthan oder Butanon. Die erwähnten Lösungsmittel können mit anderen Lösungsmitteln, in denen die zu lösenden Substanzen nicht unbedingt löslich sein müssen, verschnitten werden ; hierzu gehören hauptsächlich Äther und Ester, wie Dioxan, Tetrahydrofuran, Butylacetat und Äthylenglykolmethylätheracetat.

In Verbindung mit den fluorierten Netzmitteln haben sich Glykolmonoalkyläther, z. B. Äthylenglykolmonomethyläther, aliphatische Ester, z. B. Butylacetat, cyclische Ketone, z. B. Cyclohexanon, cyclische Äther, z. B. Tetrahydrofuran, oder chlorierte Kohlenwasserstoffe, z. B. Dichloräthan, als gut lösende Komponente besonders bewährt.

Die Polyglykoläther von hochfluorierten bzw. perfluorierten Alkoholen sind besonders in Glykolmonoäthern wirksam. Dieser Typ von fluorierten Netzmitteln zeigt auch in wäßrigen Lösungen eine gute Wirksamkeit. Im allgemeinen werden aber organische Lösungsmittel bevorzugt.

Bei Zusatz der angegebenen fluorierten Netzmittel zu der Beschichtungslösung wird es überraschenderweise möglich, mit einem einzigen Lösungsmittel auszukommen und Schichten von besserer Qualität zu erhalten, als man sie bisher mit Kombinationen von Lösungsmitteln, wie oben beschrieben, herstellen konnte. Es liegt auf der Hand, daß sich die Rückgewinnung und Reinigung eines einzigen Lösungsmittels technologisch wesentlich einfacher gestaltet als die entsprechende Verarbeitung von Lösungsmittelgemischen. Insbesondere ist es wesentlich einfacher, ein relativ hochsiedendes Lösungsmittel aus der Abluft zu entfernen als ein Gemisch von hoch- und niedrigsiedenden Anteilen.

Als alleinige Lösungsmittel sind die oben genannten gut lösenden Verbindungen, besonders die Glykolmonoäther, geeignet. Sie sind aufgrund ihres guten Lösevermögens für verschiedenartige Substanzen universell für Kopierschichten unterschiedlicher Arten, z. B. Schichten auf Basis von negativ oder positiv arbeitenden Diazoverbindungen, photopolymerisierbare Schichten, photoleitfähige Schichten und andere, zu verwenden. Auch können die verschiedensten Trägermaterialien nach dem erfindungsgemäßen Verfahren mit Vorteil beschichtet werden.

Außer den genannten allgemein gültigen, durch die Verwendung eines einzigen Lösungsmittels erzielten Vorteilen bei der Herstellung werden bei Verwendung bestimmter Lösungsmittel, wie Glykolmonoäthern, z. B. von Äthylenglykolmonomethyläther, als einzige Lösungsmittel von Beschichtungslösungen für die Herstellung von vorsensibilisierten Druckplatten, insbesondere Flachdruckplatten, überraschenderweise auch Vorteile im kopiertechnischen Verhalten gegenüber Materialien erzielt, die aus Lösungsmittelgemischen, aber ohne Zusatz von fluoriertem Netzmittel, hergestellt wurden.

Je nach der Art des lichtempfindlichen Systems treten als Vorteile besserer Belichtungskontrast, geringere Entwicklungszeit, geringerer Entwicklerverbrauch, höhere Entwicklerresistenz, höhere Lichtempfindlichkeit, höhere Auflösung und/oder geringere Unterstrahlungsneigung in Erscheinung. Diese

Vorteile treten bei einem bestimmten Plattentyp in der Regel nicht alle zugleich auf und sind je nach Plattentyp unterschiedlich stark ausgeprägt.

Im Druckverhalten, wie Farbannahme, Wasserführung und Druckauflage, sind zwischen aus Glykoläthern unter Zusatz fluorierter Netzmittel beschichteten Flachdruckplatten und solchen, die aus Lösungsmittelgemischen ohne Netzmittelzusatz beschichtet wurden, im allgemeinen keine Unterschiede festzustellen.

Die lichtempfindlichen Schichten, die unter Verwendung der fluorierten Netzmittel auf Schichtträger aufgebracht werden können, können in ihrer Natur und Zusammensetzung stark variieren. Unter lichtempfindlichen Schichten sollen hier auch solche verstanden werden, deren Lichtempfindlichkeit erst durch eine Vorbehandlung, z. B. elektrostatische Aufladung, nutzbar gemacht wird, also elektrophotographische Schichten.

Auch sollen hier Schichten einbezogen sein, die in zwei Stufen hergestellt werden, also z. B. Harz- oder Bindemittelschichten, die erst durch nachträgliches Tränken oder Imprägnieren mit einer Lösung einer lichtempfindlichen Substanz, z. B. von Dichromat oder einer Diazoverbindung, lichtempfindlich gemacht werden. In diesem Falle wird das erfindungsgemäß zugesetzte Netzmittel in der ersten Stufe, d. h. bei der eigentlichen Herstellung der Schicht, verwendet. Auch sollen sowohl fabrikatorisch hergestellte Schichten, wie bei vorsensibilisierten Druckplatten, als auch vom Anwender des lichtempfindlichen Materials selbst aufgebrachte Schichten, also Photoresistschichten oder selbstbeschichtete Druckplatten, umfaßt werden. Ebenso sind reprographische Kopierschichten einzubeziehen, die nicht gegen sichtbares oder langwelliges UV-Licht, wohl aber gegen energiereiche Strahlung, wie Elektronen- oder Laserstrahlung empfindlich sind. Grundsätzlich findet die Erfindung auf alle reprographischen Schichten Anwendung, bei denen es auf einheitliche, homogene Beschaffenheit und Schichtdicke ankommt.

Als lichtempfindliche Systeme kommen alle diejenigen in Betracht, die durch Belichtung bzw. Bestrahlung ihre Löslichkeit in einem Entwickler verändern, also lichthärtbare (negative) oder durch Belichten löslich werdende (positive) Gemische. Es kommen ferner die elektrophotographischen Systeme in Betracht, mit deren Hilfe ein Ladungsbild, ggf. ein Tonerbild und schließlich, z. B. durch Übertragung des Ladungs- oder Tonerbilds oder durch Entschichtung der nicht vom Tonerbild bedeckten Bereiche, ein Reliefbild, z. B. für eine Druckform, erzeugt wird.

Geeignet sind vor allem lichtempfindliche Gemische auf Basis von positiv oder negativ arbeitenden Diazoverbindungen, z. B. o-Chinondiaziden oder Diazoniumsalz-Polykondensationsprodukten. Diese Gemische enthalten häufig filmbildende Harze oder Bindemittel. Geeignete positiv arbeitende Schichten dieser Art sind z. B. in den DE-OS 23 31 377, 25 47 905 und 28 28 037, negativ arbeitende Schichten des genannten Typs z. B. in der US-PS 3 867 147 beschrieben.

Weiterhin geeignet sind positiv arbeitende Gemische auf Basis von Verbindungen mit säurespaltbaren Orthocarbonsäure- oder Acetalgruppen und photolytischen Säurespendern, wie sie z. B. in der DE-PS 26 10 842 und den DE-OS 27 18 254 und 29 28 636 beschrieben sind.

Ferner können photopolymerisierbare Gemische aus äthylenisch ungesättigten polymerisierbaren Verbindungen, Photoinitiatoren und ggf. polymeren Bindemitteln verwendet werden, wie sie z. B. in der US-PS 2 760 863, der DE-PS 20 27 467 und den DE-OS 20 64 079, 23 63 806 und 28 22 190 beschrieben sind.

Wie bereits erwähnt, können ebenfalls photoleitfähige Materialien aus anorganischen oder organischen Photoleitern und ggf. polymeren Bindemitteln verwendet werden, wie sie z. B. in den DE-PS 23 22 047, 15 22 497 und 18 11 209 und der DE-AS 27 26 116 beschrieben sind.

Als Schichtträger werden in bekannter Weise Metalle, wie Aluminium, Kupfer, verchromtes Kupfer oder Messing, Stahl oder dgl., Kunststoffolien, z. B. aus Celluloseacetat oder Polyäthylenterephthalat, kupferkaschierte Preßharzplatten und dgl. verwendet.

Die Beschichtung kann durch Antragen mit Walzen, Wannen, Breitschlitzdüsen, durch Gießen oder dgl. erfolgen. Die Art des Aufbringens der Lösung hat wenig oder gar keinen Einfluß auf die vergleichmäßigende Wirkung der zugesetzten fluorierten Netzmittel.

Die nach dem erfindungsgemäßen Verfahren erhaltenen beschichteten Kopiermaterialien werden in bekannter Weise durch bildmäßiges Belichten oder Bestrahlen und Auswaschen der Nichtbildbereiche mit einem Entwickler, vorzugsweise einer wäßrigen Entwicklerlösung, in das gewünschte Reliefbild übergeführt. Dabei werden die in der Schicht enthaltenen fluorierten Netzmittel zusammen mit den löslichen Schichtbereichen so vollständig von den Nichtbildstellen entfernt, daß der hier freigelegte Träger keine Neigung zum Tonen zeigt.

In der vorstehenden Beschreibung und in den Beispielen wird im wesentlichen auf die Herstellung von Flachdruckformen als wichtigstes Anwendungsgebiet des erfindungsgemäßen Materials und Verfahrens Bezug genommen. Mit Vorteil läßt sich die Erfindung auch bei der Herstellung von anderen Druckplattenarten, wie Hoch- oder Tiefdruckplatten, oder bei der Herstellung von Photoresists und anderen reprographischen Materialien anwenden, wo es auf das Aufbringen licht- oder strahlungsempfindlicher Schichten von gleichmäßiger Schichtdicke und Qualität ankommt.

Die folgenden Beispiele erläutern bevorzugte Ausführungsformen der Erfindung. Gewichtsteile (Gt) und Volumteile (Vt) stehen im Verhältnis von g zu ccm. Prozentzahlen und Mengenverhältnisse sind, wenn nichts anderes angegeben ist, in Gewichtseinheiten zu verstehen.

## Beispiel 1

Auf ein elektrolytisch aufgerauhtes und anodisiertes Aluminiumband wurde durch Fließbeschichtung mittels einer Breitschlitzdüse die folgende Lösung aufgebracht :

6,6 Gt Kresol-Formaldehyd-Novolak mit dem Erweichungsbereich 105-120 °C nach DIN 53 181,
1,1 Gt des 4-(2-Phenyl-prop-2-yl)-phenylesters der Naphthochinon-(1,2)-diazid-(2)-sulfonsäure-(4),
0,6 Gt 2,2′-Bis-[naphthochinon-(1,2)-diazid-(2)-sulfonyloxy-(5)]-dinaphthyl-(1,1′)-methan,
0,24 Gt Naphthochinon-(1,2)-diazid-(2)-sulfochlorid-(4),
0,08 Gt Kristallviolett,
0,02 Gt des Veresterungsprodukts aus einem Polyglykol mit Oxyäthylen- und Oxypropyleneinheiten und einer Perfluoralkancarbonsäure,
91,36 Gt Lösungsmittelgemisch aus 4 Vt Äthylenglykolmonomethyläther, 5 Vt Tetrahydrofuran und 1 Vt Butylacetat.

Das beschichtete Band wurde im Trockenkanal bei Temperaturen bis 120 °C getrocknet.

Die erhaltene Schicht hatte ein völlig gleichmäßiges, von wolkigen Unregelmäßigkeiten freies Aussehen. Es war dadurch möglich, kleine Beschichtungsfehler im Rahmen einer größeren Produktionsoperation leicht zu erkennen.

Die so hergestellten Druckplatten wurden unter einer Positivvorlage belichtet und mit einem Entwickler der folgenden Zusammensetzung entwickelt :

5,3 Gt Natriummetasilikat × 9 $H_2O$,
3,4 Gt Trinatriumphosphat × 12 $H_2O$,
0,3 Gt Natriumdihydrogenphosphat (wasserfrei),
91,0 Gt Wasser.

Die erhaltenen Druckformen waren kopier- und drucktechnisch fehlerfrei.

In gleicher Weise wie oben beschrieben wurden Druckplatten durch Beschichten mit einer Lösung hergestellt, die keinen Perfluoralkancarbonsäureester enthielt, jedoch im übrigen die gleiche Zusammensetzung hatte wie die oben angegeben Beschichtungslösung.

Die Kopierschichten waren visuell ungleichmäßig und uneinheitlich gefärbt. Sie wiesen nach Größe und Anzahl etwa gleichmäßig verteilte hellere und dunklere Zonen auf, die in der Beschichtungsrichtung mehr oder weniger stark ausgezogen waren. Je $cm^2$ waren im Mittel etwa 3 bis 5 helle und dunkle Zonen zu erkennen. Das Aussehen derartiger Schichten wird allgemein als « wolkig » bezeichnet.

Das kopier- und drucktechnische Verhalten der wie zuletzt beschrieben hergestellten Druckformen war das gleiche wie bei den erfindungsgemäß hergestellten Druckformen.

## Beispiel 2

Es wurde wie in Beispiel 1 gearbeitet, jedoch wurde der Perfluoralkancarbonsäureester in der Beschichtungslösung durch 0,05 Gt eines Fluoralkyläthers der Formel $C_7F_{15}C_2H_4(OC_2H_4)_{5-6}OH$ ersetzt. Die erhaltenen Druckplatten wiesen das gleiche Erscheinungsbild auf wie die gemäß Beispiel 1 und zeigten das gleiche kopier- und drucktechnische Verhalten.

## Beispiel 3

Es wurde wie in Beispiel 1 gearbeitet, jedoch wurde zur Herstellung der Beschichtungslösung anstelle des angegebenen Lösungsmittelgemischs die gleiche Menge Äthylenglykolmonomethyläther als einziges Lösungsmittel verwendet. Die Beschichtungsqualität war die gleiche wie in Beispiel 1.

Beim Belichten zeigten die so hergestellten Druckplatten einen deutlich höheren Bildkontrast, eine geringfügig höhere Lichtempfindlichkeit und eine geringere Unterstrahlungsneigung als die in Beispiel 1 beschriebenen Vergleichsplatten, die ohne fluoriertes Netzmittel, aber mit einem Lösungsmittelgemisch hergestellt worden waren.

Beim Entwickeln der belichteten Druckplatten konnte bei einer um 20 % reduzierten Menge an Entwickler die Entwicklungszeit um 14 % gegenüber den oben genannten Vergleichsplatten verkürzt werden.

Hinsichtlich Farbannahme, Wasserführung und Druckauflage ist kein Unterschied zu dem Vergleich zu erkennen.

Wenn anstelle von Äthylenglykolmonomethyläther die gleiche Menge Cyclohexanon, Tetrahydrofuran oder Dioxan als einziges Lösungsmittel verwendet wurde, wurden hinsichtlich Beschichtungsqualität sowie des kopier- und drucktechnischen Verhaltens der Platten im wesentlichen gleiche Ergebnisse erhalten.

Wenn anstelle des in Beispiel 1 angegebenen fluorierten Netzmittels das in Beispiel 2 genannte verwendet wurde, wurden praktisch die gleichen Ergebnisse erhalten.

Wurde bei sonst gleicher Beschichtungslösung das fluorierte Netzmittel ganz fortgelassen, so ergab sich eine extrem wolkige, ungleichmäßige, in der Beschichtungsqualität nicht akzeptable Kopierschicht.

### Beispiel 4

Mit einer Lösung von

1,50 Gt des Esters aus 1 Mol 2,4-Dihydroxy-3,5-dibrom-benzophenon und 2 Mol Naphthochinon-(1,2)-diazid-(2)-5-sulfonsäure,
5,20 Gt eines Phenol-Formaldehyd-Novolaks mit 14 % phenolischen OH-Gruppen und einem Erweichungspunkt von 110-120 °C nach DIN 53 181,
0,20 Gt Polyvinylbutyral,
0,15 Gt Kristallviolett,
0,08 Gt Sudangelb GGN (C.I. 11 021),
0,60 Gt Tris-(β-chloräthyl)-phosphat und
0,02 Gt des in Beispiel 2 angegebenen fluorierten Netzmittels in
92,25 Gt eines Lösungsmittelgemisches aus 40 Vt Äthylenglykolmonomethyläther und 50 Vt Tetrahydrofuran

wurde eine durch Strahldrahtbürsten aufgerauhte Aluminiumfolie beschichtet und anschließend bei Temperaturen bis 110 °C im Trockenkanal getrocknet.

Die so hergestellten positiv arbeitenden vorsensibilisierten Flachdruckplatten weisen eine sehr gleichmäßige lichtempfindliche Schicht auf. Die kopier- und drucktechnischen Eigenschaften der Platten sind einwandfrei.

Verwendet man statt des fluorierten Netzmittels von Beispiel 1 das von Beispiel 2, so werden Druckplatten von vergleichbarer Schichtqualität und vergleichbaren Verarbeitungseigenschaften erhalten.

### Beispiel 5

Eine vorsensibilisierte Druckplatte wurde durch Beschichten eines Trägers wie in Beispiel 4 hergestellt, jedoch mit der Abwandlung, daß das Lösungsmittelgemisch durch die gleiche Menge Äthylenglykolmonomethyläther als einziges Lösungsmittel ersetzt wurde. Es wurde eine Druckplatte erhalten, deren Schichtqualität derjenigen von Beispiel 4 entsprach.

Die hier erhaltene Druckplatte zeichnete sich durch leichtere Entwickelbarkeit, bessere Entwicklerresistenz der Bildstellen und geringere Unterstrahlungsneigung gegenüber einer Platte aus, die wie in Beispiel 4, aber ohne Zusatz von fluoriertem Netzmittel hergestellt wurde. Drucktechnisch wurden etwa die gleichen Ergebnisse erhalten wie mit der Vergleichsplatte.

### Beispiel 6

Eine elektrolytisch aufgerauhte und anodisierte Aluminiumplatte wurde 1 Minute in eine 60 °C warme Lösung von 0,3 Gew.-% Polyvinylphosphonsäure in Wasser getaucht, danach abgespült, getrocknet und mit der nachstehenden Lösung beschichtet und getrocknet:

0,7 Gt des Polykondensationsprodukts aus 1 Mol 3-Methoxy-diphenylamin-4-diazoniumsulfat und 1 Mol 4,4'-Bis-methoxymethyl-dephenyläther, ausgefällt als Mesitylensulfonat,
3,4 Gt 85%ige Phosphorsäure,
3,0 Gt eines modifizierten Epoxidharzes, erhalten durch Umsetzen von 50 g eines Epoxidharzes mit einem Molgewicht unterhalb 1 000 und 12,8 g Benzoesäure in Äthylenglykolmonomethyläther in Gegenwart von Benzyltrimethylammoniumhydroxid,
0,44 Gt feingemahlenes Heliogenblau G (C.I. 74 100),
0,02 Gt des Veresterungsprodukts aus Polyäthylenglykol und einer Perfluoralkancarbonsäure,
62,0 Gt Äthylenglykolmonomethyläther,
30,6 Gt Tetrahydrofuran und
8,0 Gt Äthylenglykolmethylätheracetat.

Die erhaltene Kopierschicht war deutlich gleichmäßiger und in der Färbung einheitlicher als eine sonst entsprechende Kopierschicht, die ohne Zusatz des fluorierten Netzmittels hergestellt worden war. Die Druckplatte hatte die gleichen kopier- und drucktechnischen Eigenschaften wie die Vergleichsplatte. Beide Platten wurden mit einer Lösung von

2,8 Gt $Na_2SO_4 \times 10\ H_2O$,
2,8 Gt $MgSO_4 \times 7\ H_2O$,
0,9 Gt Orthophosphorsäure (85 %),
0,08 Gt phosphoriger Säure,
1,6 Gt nichtionischem Netzmittel,
10,0 Gt Benzylalkohol,
20,0 Gt n-Propanol,
60,0 Gt Wasser

entwickelt.

Beispiel 7

Es wurde wie in Beispiel 6 gearbeitet, jedoch wurde anstelle des Lösungsmittelgemischs zur Beschichtung Äthylenglykolmonomethyläther als einziges Lösungsmittel verwendet.

Es wurde eine Kopierschicht von hoher Gleichmäßigkeit, einheitlicher Schichtdicke und Färbung erhalten.

Die so erhaltene Kopierschicht wies gegenüber einer aus dem Lösungsmittelgemisch ohne Zusatz von fluoriertem Netzmittel hergestellten Schicht eine höhere Lichtempfindlichkeit sowie eine verbesserte Auflösung auf.

Für die Entwicklung der Schicht, die unter Zusatz von fluoriertem Netzmittel hergestellt worden war, war eine um 30 % kürzere Entwicklungszeit erforderlich als für die Vergleichsplatte. Drucktechnisch verhielten sich beide Platten gleich.

Beispiel 8

Ein Aluminiumträger, der durch Bürsten mit einer wäßrigen Schleifmittelsuspension aufgerauht und dann mit einer wäßrigen Lösung von Polyvinylphosphonsäure behandelt worden war, wurde mit der folgenden Lösung beschichtet :

0,6 Gt des in Beispiel 6 angegebenen Diazoniumsalz-Kondensationsprodukts,
0,06 Gt Phosphorsäure (85 %),
1,7 Gt Polyvinylformal (Molgewicht 30 000, 7 % Hydroxygruppen, 20-27 % Acetatgruppen),
2,7 Gt einer Dispersion eines Kupferphthalocyaninpigments (C.I. 74 160) in Äthylenglykolmethylätheracetat,
0,02 Gt des in Beispiel 6 angegebenen fluorierten Netzmittels und
95 Gt Äthylenglykolmonomethyläther.

Die Kopierschicht zeichnet sich durch eine hohe Gleichmäßigkeit aus.

Die Schicht ist nach bildmäßigem Belichten leichter entwickelbar als eine sonst entsprechende Schicht, die ohne Zusatz von fluoriertem Netzmittel aus einem Gemisch von 50 Gt Äthylenglykolmonomethyläther, 40 Gt Tetrahydrofuran und 10 Gt Butylacetat als Lösungsmittel hergestellt wurde. Die Entwicklung erfolgte mit der folgenden Lösung :

5,7 Gt $MgSO_4 \times 7\ H_2O$;
25,5 Gt n-Propanol,
1,1 Gt Äthylenglykolmono-n-butylester,
0,7 Gt Alkyl-polyäthoxy-äthanol,
67,0 Gt Wasser.

Beispiel 9

Die in Beispiel 8 beschriebene Beschichtungslösung wurde auf einen elektrolytisch aufgerauhten und anodisierten Aluminiumträger, der mit einer wäßrigen Lösung von Polyvinylphosphonsäure nachbehandelt worden war, aufgebracht.

Die nach Trocknen der Beschichtung erhaltene vorsensibilisierte Flachdruckplatte wies neben einer hohen Beschichtungsqualität eine etwas höhere Lichtempfindlichkeit auf und erforderte eine deutlich kürzere Entwicklungszeit bei vollständigerer Entwicklung der Feinstrichelemente im Vergleich zu einer Platte, die aus einem Lösungsmittelgemisch von 50 Gt Äthylenglykolmonomethyläther, 40 Gt Tetrahydrofuran und 10 Gt Butylacetat, aber ohne Zusatz von fluoriertem Netzmittel, beschichtet worden war.

Wenn in diesem Beispiel der Äthylenglykolmonomethyläther durch Cyclohexanon, Tetrahydrofuran, Dioxan oder Dichloräthan, jeweils als einziges Lösungsmittel, ersetzt wurde, wurden im wesentlichen die gleichen Ergebnisse erhalten.

Beispiel 10

Eine elektrolytisch aufgerauhte und anodisierte Aluminiumplatte, die mit einer wäßrigen Lösung von Polyvinylphosphonsäure nachbehandelt worden war, wurde mit der folgenden Lösung beschichtet:

1 Gt der in Beispiel 6 angegebenen Diazoniumverbindung,
0,5 Gt des in Beispiel 8 angegebenen Polyvinylformals,
0,03 Gt des in Beispiel 2 angegebenen Perfluoralkyläthers,
98,5 Gt Äthylenglykolmonomethyläther.

Die nach dem Trocknen erhaltene vorsensibilisierte Flachdruckplatte wurde mit einem Argonlaser bei 10 Watt Leistung bildmäßig bestrahlt und mit der folgenden Lösung entwickelt:

6 Gt Magnesiumsulfat,
0,7 Gt Fettalkoholpolyglykoläther,
65 Gt Wasser,
32 Gt n-Propanol.

Zum Vergleich wurden die gleichen Schichtbestandteile aus einem Lösungsmittelgemisch von 40 Vt Tetrahydrofuran und 60 Vt Äthylenglykolmonomethyläther, jedoch ohne Zusatz des Perfluoralkyläthers auf den Träger aufgebracht. Diese Platte hatte eine wesentlich schlechtere Schichtqualität und erforderte eine deutlich längere Belichtungszeit.

Bei Beschichtung aus Äthylenglykolmonomethyläther als einzigem Lösungsmittel und ohne Zusatz von fluoriertem Netzmittel wurde eine extrem wolkige Schicht mit starken Schichtdichteschwankungen erhalten.

Beispiel 11

Eine Lösung von

10 Gt 2,5-Bis-(4'-diäthylaminophenyl)-1,3,4-oxdiazol,
10 Gt eines Mischpolymerisats aus Styrol und Maleinsäureanhydrid mit dem mittleren Molekulargewicht 20 000 und der Säurezahl 180,
0,02 Gt Rhodamin FB (C.I. 45 170) und
0,02 Gt des in Beispiel 6 angegebenen fluorierten Netzmittels in
300 Gt Äthylenglykolmonomethyläther

wurde auf eine elektrolytisch aufgerauhte, anodisierte und mit Polyvinylphosphonsäure behandelte Aluminiumfolie aufgebracht. Die nach dem Verdampfen des Lösungsmittels verbleibende Photoleiterschicht ist sehr gleichmäßig und weist keine sichtbaren Strukturierungen auf.

Die Schicht wurde im Dunklen mittels einer Corona auf etwa 400 V negativ aufgeladen. Die aufgeladene Platte wurde in einer Reprokamera bildmäßig belichtet und anschließend mit einem elektrophotographischen Suspensionsentwickler entwickelt, der durch Dispergieren von 3,0 g Magnesiumsulfat in einer Lösung von 7,5 g Pentaerythritharzester in 1 200 ml eines Isoparaffingemischs mit einem Siedebereich von 185-210 °C erhalten worden war. Nach Entfernen der überschüssigen Entwicklerflüssigkeit wurde die Platte 60 Sekunden in eine Lösung aus

35 Gt Natriummetasilikat × 9 $H_2O$,
140 Vt Glycerin,
550 Vt Äthylenglykol und
140 Vt Äthanol

getaucht. Die Platte wurde dann mit einem kräftigen Wasserstrahl abgespült, wobei die nicht mit Toner bedeckten Stellen der Photoleiterschicht entfernt wurden. Die Platte ist dann druckfertig.

Da das verwendete Netzmittel eine nichtionogene Substanz ist, bleiben die Aufladbarkeit der elektrophotographischen Schicht sowie der Ladungsabfluß bei der Belichtung unbeeinflußt.

Die in der Beschichtungsqualität verbesserte Platte unterscheidet sich, was Verarbeitungseigenschaften und Druckverhalten betrifft, nicht von einer Vergleichsplatte, die aus einem Lösungsmittelgemisch aus 3 Gt Tetrahydrofuran, 2 Gt Äthylenglykolmonomethyläther und 1 Gt Butylacetat ohne Zusatz von fluoriertem Netzmittel beschichtet wurde.

Eine in sonst gleicher Weise, aber ohne Zusatz von fluoriertem Netzmittel und mit Äthylenglykolmonomethyläther als einzigem Lösungsmittel hergestellte Platte zeigte eine bereits mit bloßem Auge erkennbare Runzelstruktur.

Beispiel 12

Eine Lösung von

10 Gt des in Beispiel 6 angegebenen Diazoniumsalz-Kondensationsprodukts,
4 Gt des Azofarbstoffs aus 2,4-Dinitro-6-chlor-benzoldiazoniumsalz und 2-Methoxy-5-acetyl-amino-N-hydroxyäthyl-N-cyanoäthylanilin,
1 Gt Metanilgelb (C.I. 13 065),
2 Gt Phosphorsäure (85 %) und
0,2 Gt des in Beispiel 6 angegebenen fluorierten Netzmittels in
970 Gt Äthylenglykolmonomethyläther

wurde auf eine elektrolytisch aufgerauhte und anodisierte Aluminiumfolie aufgebracht. Es wurde eine wolkenfreie, gleichmäßige Schicht erhalten.

Beispiel 13

Eine Lösung von

28 Gt einer 50%igen wäßrigen Dispersion eines Terpolymerisats aus Vinylacetat, Äthylen und Vinylchlorid,
4 Gt einer 32%igen Kupferphthalocyanindispersion (C.I. 74 160) in Äthylenglykol/Wasser 3 : 1,
4 Gt des in Beispiel 6 angegebenen Diazoniumsalz-Kondensationsprodukts,
0,3 Gt Metanilgelb,
0,2 Gt Phosphorsäure (85 %) und
0,2 Gt des in Beispiel 6 angegebenen fluorierten Netzmittels in
970 Gt Äthylenglykolmonomethyläther

wurde auf eine elektrolytisch aufgerauhte und anodisierte Aluminiumplatte aufgebracht. Dabei wurde eine wolkenfreie Kopierschicht erhalten. Wenn dagegen das fluorierte Netzmittel aus der Beschichtungslösung fortgelassen wurde, wurde eine stark wolkige Schicht ungleichmäßiger Dicke erhalten.

Beispiel 14

Auf eine elektrolytisch aufgerauhte und anodisierte Aluminiumplatte wurde eine Lösung von

10 Gt eines Polykondensationsprodukts aus 1 Mol 3-Methoxy-diphenylamin-4-diazoniumsalz und 1 Mol 4,4'-Bis-methoxymethyldiphenyläther, ausgefällt als Methansulfonat,
5 Gt 47%iger Dispersion des Pigmentfarbstoffs Pigmentgrün 7 (C.I. 74 260) in Äthylenglykol/Wasser 3 : 1,
5 Gt eines äthoxylierten Octylphenols,
3 Gt Phosphorsäure (85 %) und
0,2 Gt des in Beispiel 2 beschriebenen Fluoralkyläthers in
680 Gt Wasser

aufgebracht und getrocknet. Es wurde eine sehr gleichmäßige, in der Färbung einheitliche Kopierschicht erhalten. Wenn die gleiche Beschichtungslösung ohne Zusatz des Fluoralkyläthers auf gleiches Trägermaterial aufgebracht wurde, wurde eine stark fleckige Kopierschicht erhalten.

Beispiel 15

Eine Lösung aus

14 Gt eines Mischpolymerisats aus Methylmethacrylat und Methacrylsäure mit dem mittleren Molekulargewicht 40 000 und einer Säurezahl von 90-115,
14 Gt 1,1,1-Trimethylol-äthan-triacrylat,
2 Gt 1,6-Bis-hydroxyäthoxy-hexan,
0,5 Gt 9-(p-Hydroxy-phenyl)-acridin und
0,02 Gt des in Beispiel 1 angegebenen fluorierten Netzmittels in
130 Gt Äthylenglykolmonoäthyläther

wurde auf eine elektrolytisch aufgerauhte und anodisierte Aluminiumfolie aufgebracht und getrocknet.
Die erhaltene photopolymerisierbare Kopierschicht war wolkenfrei und völlig gleichmäßig.
Die Schicht wurde unter einer Vorlage mit einer 5 kW Xenon-Punktlichtlampe 1 Minute belichtet. Sie wurde dann mit einem Entwickler aus

15 Gt Natriummetasilikat × 9 $H_2O$,
3 Gt Polyglykol 6000,
0,6 Gt Lävulinsäure und
0,3 Gt Strontiumhydroxid × 8 $H_2O$ in
1 000 Gt Wasser

1 Minute überwischt, wobei die unbelichteten Schichtbereiche entfernt wurden. Dann wurde mit Wasser abgespült, mit 1%iger Phosphorsäure fixiert und abschließend mit schwarzer Fettfarbe eingefärbt.

Wenn die gleiche Beschichtung ohne Zusatz von fluoriertem Netzmittel aus Äthylenglykolmonomethyläther als einzigem Lösungsmittel aufgebracht wurde, wurde eine wolkige und ungleichmäßige Kopierschicht erhalten.

Wenn ein Gemisch aus 70 Vt Äthylenglykolmonoäthyläther und 30 Vt Äthylenglykolmonobutyläther als Beschichtungslösungsmittel verwendet wurde, wurde ebenfalls eine wolkige Kopierschicht erhalten, die eine verlängerte Belichtungszeit gegenüber der Netzmittel enthaltenden Schicht erforderte.

## Beispiel 16

Eine Lösung aus

25 Gt Bis-(5-äthyl-5-butyl-1,3-dioxan-2-yl)-äther des 2-Äthyl-2-butyl-1,3-propandiols,
71 Gt Kresol-Formaldehyd-Novolak wie in Beispiel 1,
3 Gt 2-(Acenaphth-5-yl)-4,6-bis-trichlormethyl-s-triazin,
0,7 Gt Kristallviolett-Base und
0,2 Gt des in Beispiel 1 angegebenen fluorierten Netzmittels in
900 Gt Äthylenglykolmonomethyläther

wurde auf eine elektrolytisch aufgerauhte und anodisierte Aluminiumfolie aufgebracht und getrocknet. Die erhaltene positiv arbeitende Kopierschicht war wolkenfrei und zeichnete sich durch hohe Beschichtungsqualität aus.

Die Platte wurde in üblicher Weise unter einer Vorlage belichtet und dann mit dem in Beispiel 1 angegebenen Entwickler entwickelt.

Ähnliche Ergebnisse wurden erhalten, wenn statt des angegebenen Orthoesterderivats andere Orthocarbonsäureester, die in der DE-OS 26 10 842 beschrieben sind, oder Polyacetale verwendet wurden, wie sie in der DE-OS 27 18 254 beschrieben sind.

## Beispiel 17

Eine Lösung aus

2 Gt des Esters aus 1 Mol 2,3,4-Trihydroxy-benzophenon und 3 Mol Naphthochinon-(1,2)-diazid-(2)-5-sulfonsäure,
3 Gt Zaponechtblau HFL (C.I. 74 350),
1 Gt Sudanblau II (C.I. 61 554 S) und
0,02 Gt des in Beispiel 6 angegebenen fluorierten Netzmittels in
94 Gt eines Gemischs aus 30 Vt Äthylenglykolmonomethyläther, 20 Vt Methyläthylketon und 10 Vt Butylacetat (85 %ig)

wurde auf eine Polyesterfolie aufgebracht. Es wurde eine völlig wolkenfreie, gleichmäßig gefärbte Beschichtung auf der Folie erhalten, die als Farbprüffolie verwendet werden kann. Wenn dagegen eine entsprechende Beschichtungslösung, die kein fluoriertes Netzmittel enthält, auf den gleichen Träger aufgebracht wurde, so wurde eine Schicht mit starken Farbdichteschwankungen erhalten.

## Beispiel 18

Zur Herstellung eines Positiv-Trockenresists wurden

11,15 Gt Novolak nach Beispiel 1,
2,79 Gt Vinylacetat-Crotonsäure-Mischpolymerisat (95 : 5) vom Molekulargewicht 100.000,
4,18 Gt eines Mischpolymerisats aus 5 : 1 : 2 Teilen n-Hexylmethacrylat/Methylmethacrylat/Methacrylsäure mit der Säurezahl 158,
2,79 Gt Epoxidharz mit dem Epoxyäquivalentgewicht 190,
2,32 Gt des Bis-Naphthochinon-(1,2)-diazid-(2)-sulfonsäure-(5)-esters des 4,4-Bis-(4-hydroxy-phenyl)-valeriansäure-3-methoxy-butylesters,
0,45 Gt 1,2-Naphthochinon-2-diazid-4-sulfochlorid

0,02 Gt des in Beispiel 1 beschriebenen fluorierten Netzmittels und
0,06 Gt Kristallviolett in
48,34 Gt Äthylenglykolmonoäthyläther und
27,90 Gt Methyläthylketon

gelöst. Damit wurde eine ca. 25 µm dicke, mit einer wäßrigen Lösung von 10 % Trichloressigsäure, 1 % Polyvinylalkohol und 0,1 % Netzmittel vorbehandelte Polyesterfolie beschichtet und getrocknet. Dabei wurde eine sehr gleichmäßige Beschichtung erhalten.

Das oben angeführte Lösungsmittel-Gemisch wurde ohne Einbuße der Beschichtungsqualität durch 76,24 Gt Äthylenglykolmonoäthyläther ersetzt.

Auf die ca. 20 µm dicke Resistschicht wurde dann eine Polyäthylen-Deckfolie zum Schutz gegen Staub und Verkratzungen aufgebracht.

Zur Herstellung von Leiterplatten wurde die Positiv-Trockenresistfolie nach Abziehen der Deckfolie in einem handelsüblichen Laminator auf eine gereinigte ca. 35 µm dicke Kupferfolie laminiert, die auf einen Isolierstoffträger aufkaschiert war. Nach Abziehen der Trägerfolie, evtl. Nachtrocknen, ca. 3 Minuten Belichten mit einem handelsüblichen Belichtungsgerät und ca. 2 Minuten Sprühentwickeln mit einem Entwickler der folgenden Zusammensetzung

0,6 Gt NaOH,
0,5 Gt $Na_2SiO_3 \times 5\ H_2O$,
1,0 Gt n-Butanol und
97,9 Gt Wasser

wurde eine ausgezeichnete bildmäßige Resistschicht erhalten. Sie widerstand nicht nur den Bedingungen von Ätzprozessen, z. B. mit $FeCl_3$, sondern war auch galvanoresistent bei der Herstellung durchkontaktierter Schaltungen, insbesondere bei dem galvanischen Aufbau von Kupfer, Nickel und Gold hintereinander.

## Beispiel 19

Eine Lösung von

3,0 Gt des Bis-naphthochinon-(1,2)-diazid-(2)-sulfonsäure-(5)-esters des 4,4-Bis-(4-hydroxy-phenyl) valeriansäuremethylesters,
21,0 Gt Phenol-Formaldehyd-Novolak wie in Beispiel 4,
3,0 Gt Vinylacetat-Crotonsäure-Mischpolymerisat wie in Beispiel 18,
3,0 Gt Epoxydharz (Epoxyäquivalentgewicht um 450),
0,4 Gt Sudanblau II (C.I. Solvent Blue 35) und
0,02 Gt des in Beispiel 1 beschriebenen fluorierten Netzmittels in
49.6 Gt Äthylenglykolmonoäthylätheracetat,
10,0 Gt Äthylenglykolmonoäthyläther und
10,0 Gt Butylacetat

oder in

69,6 Gt Äthylenglykolmonoäthyläther

ergab einen Positiv-Kopierlack, der sich für die Fertigung von Leiterplatten, von Kupfertiefdruckzylindern, zur Anwendung beim Formteilätzen oder für Nickelgalvanoschablonen eignet.

## Beispiel 20

Eine Lösung von

2,8 Gt eines Terpolymerisats aus Methylmethacrylat, n-Hexylmethacrylat und Methacrylsäure (25 : 125 : 30) mit der Säurezahl 202,
2,8 Gt des Umsetzungsprodukts aus 1 Mol 2,2,4-Trimethyl-hexamethylendiisocyanat und 2 Mol Hydroxyäthylmethacrylat,
0,005 Gt des in Beispiel 1 angegebenen fluorierten Netzmittels,
0,5 Gt Diäthylenglykolmonohexyläther,
0,03 Gt Tris-[4-(3-methyl-phenylamino)-phenyl]-methylacetat und
0,025 Gt 9-Phenyl-acridin in
12 Vt Äthylenglykolmonoäthyläther

wurde auf Polyäthylenterephthalatfolie von 25 µm Stärke so aufgeschleudert, daß nach dem Trocknen (8

Minuten Fön, 3 Minuten bei 100 °C im Trockenschrank) eine Schichtdicke von 25 µm erhalten wurde. Die Schicht hatte eine sehr gleichmäßige Schichtdicke und wies keine Schwankungen in der Färbung auf. Die Trockenresistfolie wurde wie in Beispiel 18 beschrieben auf eine mit Kupfer kaschierte Schichtstoffplatte aufkaschiert und belichtet. Man erhielt nach 2 Minuten Entwickeln ein sauber entwickeltes Bild der Vorlage. Die Entwicklerresistenz und Ätzresistenz sind ausgezeichnet.

**Patentansprüche**

1. Lichtempfindliches Kopiermaterial aus einem Schichtträger und einer lichtempfindlichen Schicht, die ihre Löslichkeit in einem Entwickler bei Belichtung mit aktinischem Licht ändert und die 0,01-10 Gew.-% einer fluorierten organischen Verbindung enthält, dadurch gekennzeichnet, daß die fluorierte organische Verbindung ein fluoriertes nichtionogenes Netzmittel ist, das der Ester einer Perfluoralkansäure mit einem Polyalkylenglykol oder der Äther eines hoch- oder perfluorierten Alkanols mit einem Polyalkylenglykol ist und das die Formel

$$R_f(CO)_r(OC_mH_{2m})_nOR$$

aufweist, worin
$R_f$ ein fluorierter Alkylrest mit 2 bis 12, vorzugsweise 5 bis 8 Kohlenstoffatomen,
R ein Wasserstoffatom oder ein Rest $R_f(CO)_r$,
m eine Zahl von 2 bis 5,
n eine Zahl von 4 bis 40 und
r Null oder 1
ist.

2. Lichtempfindliches Kopiermaterial nach Anspruch 1, dadurch gekennzeichnet, daß es das fluorierte Netzmittel in solcher Menge enthält, daß das Spreitvermögen der die Schichtbestandteile enthaltenden Beschichtungslösung auf einem Schichtträger durch den Zusatz des Netzmittels linear um 40 bis 75 % reduziert wird.

3. Lichtempfindliches Kopiermaterial nach Anspruch 1, dadurch gekennzeichnet, daß es das fluorierte Netzmittel in solcher Menge enthält, daß die Oberflächenspannung der lichtempfindlichen Schicht gegenüber Wasser um 2 bis 12 mN/m im Vergleich zur netzmittelfreien Schicht herabgesetzt ist.

4. Lichtempfindliches Kopiermaterial nach Anspruch 1, dadurch gekennzeichnet, daß die Löslichkeit der lichtempfindlichen Schicht durch Belichten erhöht wird.

5. Lichtempfindliches Kopiermaterial nach Anspruch 4, dadurch gekennzeichnet, daß die lichtempfindliche Schicht als lichtempfindliche Verbindung ein o-Chinondiazid enthält.

6. Lichtempfindliches Kopiermaterial nach Anspruch 1, dadurch gekennzeichnet, daß die Löslichkeit der lichtempfindlichen Schicht durch Belichten herabgesetzt wird.

7. Lichtempfindliches Kopiermaterial nach Anspruch 6, dadurch gekennzeichnet, daß die Schicht als lichtempfindliche Verbindung ein Diazoniumsalz-Polykondensationsprodukt enthält.

8. Lichtempfindliches Kopiermaterial nach Anspruch 6, dadurch gekennzeichnet, daß die lichtempfindliche Schicht eine photopolymerisierbare Schicht ist.

9. Verfahren zum Beschichten eines Schichtträgers mit einer lichtempfindlichen Kopierschicht, bei dem die Schichtbestandteile zusammen mit einer fluorierten organischen Verbindung in einem Lösungsmittel gelöst werden, die Lösung zu einer dünnen Schicht auf den Träger aufgebracht und durch Verdunsten des Lösungsmittels, vorzugsweise bei erhöhter Temperatur, getrocknet wird, dadurch gekennzeichnet, daß man der Beschichtungslösung 0,005 bis 1 Gew.-%, vorzugsweise 0,01 bis 0,05 Gew.-% eines nichtionogenen Netzmittels zusetzt, das der Ester einer Perfluoralkansäure mit einem Polyalkylenglykol oder der Äther eines hoch- oder perfluorierten Alkanols mit einem Polyalkylenglykol ist und das die Formel

$$R_f(CO)_r(OC_mH_{2m})_nOR$$

aufweist, worin
$R_f$ ein fluorierter Alkylrest mit 2 bis 12, vorzugsweise 5 bis 8 Kohlenstoffatomen,
R ein Wasserstoffatom oder ein Rest $R_f(CO)_r$,
m eine Zahl von 2 bis 5,
n eine Zahl von 4 bis 40 und
r Null oder 1
ist.

10. Verfahren nach Anspruch 9, dadurch gekennzeichnet, daß man das fluorierte Netzmittel in solcher Menge zusetzt, daß das Spreitvermögen der Beschichtungslösung auf einem Schichtträger linear um 40 bis 75 % reduziert wird.

11. Verfahren nach Anspruch 9, dadurch gekennzeichnet, daß man die Schichtbestanddteile im wesentlichen in einem einzigen organischen Lösungsmittel löst.

**Claims**

1. A light-sensitive copying material comprising a support and a light-sensitive layer which undergoes a change of solubility in a developer upon exposure to actinic light and which contains from 0.01 to 10 percent by weight of a fluorinated organic compound, characterized in that the fluorinated organic compound is a fluorinated non-ionic surfactant which is the ester of a perfluoroalkanoic acid and a polyalkylene glycol or an ether of a highly fluorinated or a perfluorinated alkanol with a polyalkylene glycol, which fluorinated surfactant is a compound of the formula

$$R_f(CO)_r(OC_mH_{2m})_nOR$$

in which

$R_f$ is a fluorinated alkyl group comprising from 2 to 12, preferably from 5 to 8 carbon atoms,
R is a hydrogen atom or a group $R_f(CO)_r$,
m is an integer ranging from 2 to 5,
n is an integer ranging from 4 to 40, and
r is zero or 1.

2. A light-sensitive copying material as claimed in claim 1, characterized in that it comprises the fluorinated surfactant in such a quantity that the spreading capacity on a support of the coating solution containing the layer components is reduced in a linear manner by 40 to 75 percent by the addition of the surfactant.

3. A light-sensitive copying material as claimed in claim 1, characterized in that it comprises the fluorinated surfactant in such a quantity that the surface tension of the light-sensitive layer towards water is reduced by 2 to 12 nM/m, as compared with a layer which is free of surfactant.

4. A light-sensitive copying material as claimed in claim 1, characterized in that the solubility of the light-sensitive layer is increased by exposure.

5. A light-sensitive copying material as claimed in claim 4, characterized in that the light-sensitive layer contains as the light-sensitive compound an o-quinone diazide.

6. A light-sensitive copying material as claimed in claim 1, characterized in that the solubility of the light-sensitive layer is reduced by exposure.

7. A light-sensitive copying material as claimed in claim 6, characterized in that the layer contains as the light-sensitive compound a diazonium salt polycondensation product.

8. A light-sensitive copying material as claimed in claim 6, characterized in that the light-sensitive layer is a photopolymerizable layer.

9. A process for coating a support with a light-sensitive copying layer, in which the components of the layer are dissolved in a solvent together with a fluorinated organic compound, the solution is applied to form a thin layer on the support and is then dried, preferably at an elevated temperature, by evaporation of the solvent, the process being characterized in that 0.005 to 1 percent by weight, preferably 0.01 to 0.05 percent by weight, of a non-ionic surfactant is added to the coating solution, which surfactant is the ester obtained by reacting a perfluorocarboxylic acid with a polyalkylene glycol or the ether of a highly fluorinated or a perfluorinated alkanol with a polyalkylene glycol, and which surfactant has the general formula

$$R_f(CO)_r(OC_mH_{2m})_nOR$$

in which

$R_f$ is a fluorinated alkyl group comprising from 2 to 12, preferably from 5 to 8 carbon atoms,
R is a hydrogen atom or a group $R_f(CO)_r$,
m is an integer ranging from 2 to 5,
n is an integer ranging from 4 to 40, and
r is zero or 1.

10. A process as claimed in claim 9, characterized in that the fluorinated surfactant is added in such a quantity that the spreading capacity of the coating solution on a support is reduced in a linear manner by 40 to 75 percent.

11. A process as claimed in claim 9, characterized in that the components of the layer are substantially dissolved in a single organic solvent.

**Revendications**

1. Matériau à copier photosensible, constitué d'un support de couche et d'une couche photosensible dont la solubilité dans un agent de développement est modifiée par exposition avec une lumière actinique et qui contient de 0,01 à 10 % en poids d'un composé organique fluoré, caractérisé en ce que le composé organique fluoré est un mouillant fluoré non ionique qui est l'ester d'un acide perfluoralcanoïque avec un

polyalkylèneglycol ou l'éther d'un alcanol très ou perfluoré avec un polyalkylène glycol, et répond à la formule

$$R_f(CO)_r(OC_mH_{2m})_nOR$$

dans laquelle

$R_f$ représente un groupe alkyle fluoré ayant de 2 à 12, de préférence de 5 à 8 atomes de carbone,
R représente un atome d'hydrogène ou un groupe $R_f(CO)_r$,
m est un nombre de 2 à 5,
n est un nombre de 4 à 40 et
r est 0 ou 1.

2. Matériau à copier photosensible selon la revendication 1, caractérisé en ce qu'il contient le mouillant fluoré en une quantité telle que le pouvoir d'étalement de la solution de revêtement contenant les constituants de la couche sur un support de couche est réduit linéairement de 40 à 75 % du fait de l'addition du mouillant.

3. Matériau à copier photosensible selon la revendication 1, caractérisé en ce qu'il contient le mouillant fluoré en une quantité telle que la tension superficielle de la couche photosensible vis-à-vis de l'eau est abaissée de 2 à 12 mN/m par rapport à une couche sans mouillant.

4. Matériau à copier photosensible selon la revendication 1, caractérisé en ce que la solubilité de la couche photosensible est augmentée par exposition.

5. Matériau à copier photosensible, selon la revendication 4, caractérisé en ce que la couche photosensible contient un o-quinonediazide en tant que composé photosensible.

6. Matériau à copier photosensible selon la revendication 1, caractérisé en ce que la solubilité de la couche photosensible est abaissée à l'exposition.

7. Matériau à copier photosensible selon la revendication 6, caractérisé en ce que la couche contient un produit de condensation de sel de diazonium en tant que composé photosensible.

8. Matériau à copier photosensible selon la revendication 6, caractérisé en ce que la couche photosensible est une couche photopolymérisable.

9. Procédé pour recouvrir un support de couche avec une couche à copier photosensible, dans lequel les constituants de la couche sont dissous dans un solvant avec un composé organique fluoré, la solution est appliquée en une couche mince sur le support et est séchée par évaporation du solvant, de préférence à température élevée, lequel procédé est caractérisé en ce qu'à la solution de revêtement on ajoute de 0,005 à 1 % en poids, de préférence de 0,01 à 0,05 % en poids, d'un mouillant non ionique qui est l'ester d'un acide perfluoralcanoïque avec un polyalkylène glycol ou l'éther d'un alcanol très ou perfluoré avec un polyalkylène glycol et qui répond à la formule

$$R_f(CO)_r(OC_mH_{2m})_nOR$$

dans laquelle

$R_f$ représente un groupe alkyle fluoré ayant de 2 à 12, de préférence de 5 à 8 atomes de carbone,
R représente un atome d'hydrogène ou un groupe $R_f(CO)_r$,
m est un nombre de 2 à 5,
n est un nombre de 4 à 40 et
r est 0 ou 1.

10. Procédé selon la revendication 9, caractérisé en ce qu'on ajoute le mouillant fluoré en une quantité telle que le pouvoir d'étalement de la couche de revêtement sur un support de couche est réduit linéairement de 40 à 75 %.

11. Procédé selon la revendication 9, caractérisé en ce que les constituants de la couche sont dissous essentiellement dans un solvant organique unique.